# EUROPÄISCHE PATENTSCHRIFT

(11) **EP 3 232 327 B1**
(45) Veröffentlichungstag und Bekanntmachung des Hinweises auf die Patenterteilung: **14.03.2018**
(21) Anmeldenummer: 16165503.0
(22) Anmeldetag: 15.04.2016
(51) Int. Cl.: G06F 11/26, G06F 11/36

(54) **VERFAHREN ZUM TESTEN EINES STEUERPROGRAMMS EINES STEUERGERÄTS IN EINER SIMULATIONSUMGEBUNG AUF EINEM RECHNER**
METHOD FOR TESTING A CONTROL PROGRAM OF A CONTROL UNIT IN A SIMULATION ENVIRONMENT ON A COMPUTER
PROCEDE D'ESSAI D'UN PROGRAMME DE COMMANDE D'UN APPAREIL DE COMMANDE DANS UN ENVIRONNEMENT DE SIMULATION SUR UN ORDINATEUR

(30) Priorität: 31.03.2016 DE 102016105844
(43) Veröffentlichungstag der Anmeldung: 18.10.2017
(73) Patentinhaber: dSPACE digital signal processing and control engineering GmbH, 33102 Paderborn (DE)
(72) Erfinder: Hufnagel, Thorsten, 33154 Salzkotten (DE)

(56) Entgegenhaltungen:
- EP-A1- 2 851 815
- US-A1- 2002 023 203

## Beschreibung

Die Erfindung betrifft ein Verfahren zum Testen eines Steuerprogramms eines Steuergeräts in einer Simulationsumgebung auf einem Rechner.

Aus J. Mauss "Chip simulation used to run automotive software on PC", Proceedings zu Embedded Real Time Software and Systems (ERTS) 2014, ist ein Werkzeug zum Testen von Steuergerätesoftware auf einem PC bekannt, wobei die Steuergerätesoftware auf einem emulierten Prozessor ausgeführt und Umgebungsdaten simuliert werden. Um lediglich Teile der Steuergerätesoftware zu prüfen, kann der Anwender in einer Spezifikationsdatei eine Auswahl der auszuführenden Funktionen angeben. Zur Ermittlung von Fehlern der Spezifikationsdatei kann die Ausführung der Steuergerätesoftware mittels eines Debuggers schrittweise ausgeführt werden.

Das Dokument EP-A-2851815 offenbart ein Verfahren zum Testen eines Steuerprogramms eines Steuergeräts in einer Simulationsumgebung auf einem Rechner, wobei das Steuerprogramm von einem Emulator ausgeführt wird, der seinerseits auf dem Rechner läuft. Vor diesem Hintergrund besteht die Aufgabe der Erfindung darin, ein Verfahren anzugeben, das den Stand der Technik weiterbildet.

Die Aufgabe wird durch ein Verfahren zum Testen eines Steuerprogramms eines Steuergeräts in einer Simulationsumgebung auf einem Rechner mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Verfahren zum Testen eines Steuerprogramms eines Steuergeräts in einer Simulationsumgebung auf einem Rechner bereitgestellt. Die Simulationsumgebung wird auf dem Rechner erstellt. Das Steuerprogramm wird auf einem Emulator ausgeführt, wobei der Emulator zumindest einen Teil des Steuergeräts mit einem Prozessor und einem Speicherbereich nachbildet. Der Emulator wird auf dem Rechner ausgeführt und weist eine Schnittstelle zur Ein- und Ausgabe von Daten auf, wobei Umgebungswerte aus der Simulationsumgebung über die Schnittstelle in den emulierten Speicherbereich geschrieben werden. Das Steuerprogramm weist Programmvariablen auf, wobei das Steuerprogramm zumindest einigen Programmvariablen während der Ausführung des Steuerprogramms einen Variablenwert zuweist, wobei der Variablenwert durch einen Zugriff auf eine Speicheradresse des emulierten Speicherbereichs ermittelt wird.

Der Emulator ordnet jeder Programmvariablen des Steuerprogramms einen erweiterten Wertebereich zu, wobei der einer Programmvariablen zugewiesene Variablenwert in dem erweiterten Wertebereich abgelegt wird und der Emulator Programmvariablen als fehlerbehaftet oder nicht-fehlerbehaftet markiert.

Die Markierung erfolgt anhand einer Zuordnung von nicht-fehlerbehafteten Programmvariablen zu einer ersten Kategorie und von fehlerbehafteten Programmvariablen zu einer zweiten Kategorie, wobei der erweiterte Wertebereich jeder Programmvariablen der zweiten Kategorie ein Datenfeld aufweist.

Alternativ erfolgt die Markierung der Programmvariablen anhand eines in dem erweiterten Wertebereich hinterlegten Fehlerfelds, wobei dem Fehlerfeld einer nicht-fehlerbehafteten Programmvariablen ein vorbestimmter numerischer oder nicht numerischer erster Validitätswert zugewiesen wird und dem Fehlerfeld einer fehlerbehafteten Programmvariablen ein vorbestimmter numerischer oder nicht-numerischer erster Fehlerwert zugewiesen wird, wobei sich der erste Validitätswert von dem ersten Fehlerwert unterscheidet und wobei der erweiterte Wertebereich jeder Programmvariablen ein Datenfeld aufweist.

Das Markieren wird bei der Ermittlung eines Variablenwerts vorgenommen. Wird für die Ermittlung eines Variablenwerts einer ersten Programmvariablen durch den emulierten Prozessor auf eine vorhandene und beschriebene erste Speicherdresse in dem emulierten Speicherbereich oder auf eine zweite Programmvariable zugegriffen, wobei die zweite Programmvariable der ersten Kategorie zugeordnet ist oder ein Fehlerfeld mit einem ersten Validitätswert aufweist, so wird die Programmvariable als nicht-fehlerbehaftet markiert und der ermittelte Variablenwert in dem erweiterten Wertebereich abgelegt.
Wird bei der Ermittlung eines Variablenwerts einer ersten Programmvariablen durch den emulierten Prozessor auf eine nicht vorhandene oder nicht beschriebene zweite Speicherdresse in dem emulierten Speicherbereich oder auf eine dritte Programmvariable, die der zweiten Kategorie zugeordnet ist oder ein Fehlerfeld mit einem ersten Fehlerwert aufweist, zugegriffen, so wird die erste Programmvariable als fehlerbehaftet markiert, dem Variablenwert der ersten Programmvariablen ein vorbestimmter numerischer oder nicht-numerischer zweiter Fehlerwert zugewiesen und die nicht vorhandene oder nicht beschriebene zweite Speicheradresse oder eine Kopie aller Einträge des Datenfelds der dritten Programmvariablen in das Datenfeld der ersten Programmvariablen geschrieben.

Es sei angemerkt, dass vorliegend eine sogenannte Offline-Simulation beschrieben wird, bei der die Regelungssoftware in einer simulierten Umgebung auf einem Rechner, beispielsweise einem PC getestet wird. Eine Simulation in Echtzeit ist bei Offline-Simulationen meist nicht erforderlich.

Der Emulator ermöglicht es, ein Steuerprogramm direkt in Maschinensprache auszuführen, indem der Steuergeräteprozessor emuliert wird. Als Emulator wird hier ein Programm bezeichnet, welches den Steuerrechner nachbildet und dadurch das Ausführen des Steuerprogramms auf dem durch den Emulator nachgebildeten Steuerrechner ermöglicht.

Um on-chip Funktionalitäten des Steuergeräts, wie beispielsweise einen CAN-Controller, ein AD/DA-Wandler oder weitere interne Funktionalitäten des Steuergeräts, abzubilden, wird auf eine sogenannte Steuergerätebeschreibungsdatei zurückgegriffen. Die sogenannte Steuergerätebeschreibungsdatei enthält eine Liste aller Funktionen und Variablennamen und deren zugehörigen Adressen und kann beispielsweise eine sogenannte a2l-Datei sein.

Zum Verständnis der Erfindung ist anzumerken, dass das Steuerprogramm, da es auf einem einen Prozessor emulierenden Emulator ausgeführt wird, im Rahmen des erfindungsgemäßen Verfahrens in Maschinensprache vorliegt. Dementsprechend sind die Variablen des Steuerprogramms durch Speicheradressen repräsentiert, und ein Variablenwert ist ein Wert einer Variablen, der in einer der Speicheradresse der Variablen zugeordneten Speicherzelle des emulierten Speichers hinterlegt ist. Die Verwendung des Begriffes der Variablen ist für die Beschreibung eines in Maschinensprache hinterlegten Programms in technischer Hinsicht nicht notwendig. In der Beschreibung der vorliegenden Erfindung wird der Begriff nur verwendet, um den Gegenstand der Erfindung zu veranschaulichen.

Die Erfindung ist demnach technisch gleichbedeutend auch derart formulierbar, dass Speicheradressen, an denen ein Variablenwert hinterlegt ist, ein erweiterter Wertebereich wie zuvor beschrieben zugewiesen wird, dass Speicheradressen, denen ein erweiterter Wertebereich zugewiesen ist, wie zuvor beschrieben als fehlerbehaftet oder nicht-fehlerbehaftet markierbar sind, dass bei dem Versuch, einen Variablenwert aus einer nicht vorhandenen oder nicht beschriebenen zweiten Speicheradresse in dem emulierten Speicherbereich einzulesen, die zweite Speicheradresse als fehlerbehaftet markiert wird, und dass bei dem Versuch, auf eine als fehlerbehaftet markierte dritte Speicheradresse zuzugreifen, um in einer ersten Speicheradresse einen neuen Variablenwert zu hinterlegen, die erste Speicheradresse als fehlerbehaftet markiert wird.

Mit dem Erstellen der Simulationsumgebung erzeugt der Anwender Parameter, die der Emulator für die Ausführung des Steuerprogramms benötigt. Die als Umgebungswerte bezeichneten Parameter stellen hier sowohl Werte von Variablen des Steuergeräts als auch Werte von externen Sensoren oder ähnlichem dar und können dem Steuerprogramm beispielsweise durch Bypass-Methoden zur Verfügung gestellt werden.

Der erweitere Wertebereich ermöglicht es neben dem eigentlichen Wert einer Variablen weitere Informationen, wie beispielsweise Informationen über Fehler oder ergänzende Funktionen, zu verwalten. Der erweiterte Wertebereich umfasst beispielsweise einen bestimmten Bereich eines Speichers, der der Programmvariablen zugeordnet wird und in dem neben einem Variablenwert der Programmvariablen weitere Informationen abgelegt werden.

Die Anzahl und die Art der Einträge des erweiterten Wertebereichs kann für alle Programmvariablen gleich ausgestaltet sein, wobei der erweiterte Wertebereich zusätzlich zu dem Variablenwert zur Markierung eines Fehlers ein Fehlerfeld und zur Dokumentation der Fehlerfortpflanzung ein Datenfeld aufweist. Dem Fehlerfeld wird im Falle einer fehlerbehafteten Programmvariablen ein numerischer oder nicht-numerischer erster Fehlerwert zugewiesen. Ist die Programmvariable nicht fehlerbehaftet, so wird dem Fehlerfeld ein numerischer oder nicht-numerischer erster Validitätswert zugewiesen.

Das Fehlerfeld dient dazu, eine Programmvariable als fehlerhaft oder nicht fehlerhaft zu markieren. Der dem Fehlerfeld bei dem Vorliegen eines Fehlers zugeordnete nichtnumerische oder numerische erster Fehlerwert kann somit ein beliebiger Wert sein, der jedoch eindeutig sein muss und sich von dem Fehlerfeld ohne vorliegenden Fehler zugewiesenen numerischen oder nichtnumerischen ersten Validitätswert unterscheiden muss. Beispielsweise kann dem Fehlerfeld bei nicht vorliegendem Fehler der Wert 0 als erster Validitätswert zugewiesen sein, der bei dem Auftreten eines Fehlers auf 1 als erster Fehlerwert geändert wird.

Wird die Fehlermarkierung durch Zuordnung der Programmvariablen zu unterschiedlichen Kategorien vorgenommen, so richten sich die Anzahl und die Art der Einträge des erweiterten Wertebereichs einer Programmvariablen nach der Kategorie, der die entsprechende Programmvariable zugeordnet ist.

Eine Kategorie kann beispielsweise eine Klasse im Rahmen einer objektorientierten Programmierung sein. Als Klasse wird ein Variablentyp bezeichnet, dem Attribute und Methoden zugeordnet sind. So kann ein erfindungsgemäßer Wertebereich Attribute und Methoden im Sinne einer objektorientierten Klasse umfassen. Der erweiterte Wertebereich kann sich auch aus einer oder mehrerer parallel zu der Verwaltung und Verarbeitung der Variablen geführten Listen sowie der Variablen selbst zusammensetzen, wobei beispielsweise pro Kategorie eine Liste angelegt wird und wobei die in den Listen abzulegenden Informationen von der Kategorie vorgegeben werden.

Im Falle einer Fehlermarkierung durch Zuordnung zu unterschiedlichen Kategorien, weist der erweiterte Wertebereich einer fehlerbehafteten und dadurch zur zweiten Kategorie gehörenden Programmvariablen zusätzlich zu dem Variablenwert ein Datenfeld für die Dokumentation der Fehlerfortpflanzung auf. Eine nicht-fehlerbehaftete Programmvariable gehört der ersten Kategorie an. Der erweiterte Wertebereich muss lediglich den Variablenwert aufweisen. Ein Datenfeld ist nicht notwendig.

Das Erkennen einer fehlerhaften Programmvariablen kann anhand des Variablenwerts selbst möglich sein, beispielsweise wenn der zweite Fehlerwert ein nicht-numerischer und im Rahmen des Steuerprogramms eindeutiger Wert ist. Ein sicheres Erkennen einer fehlerbehafteten Programmvariablen ist anhand des Werts des Fehlerfelds oder anhand der Kategorie der Programmvariablen möglich.

Der zweite Fehlerwert, der beim Zugriff auf eine fehlerhafte Speicheradresse oder eine fehlerhafte Variable dem Variablenwert zugewiesen wird, kann ein beliebiger nichtnumerischer Fehlerwert, z.B. "error", sein, der eindeutig von validen, typischerweise numerischen Variablenwerten unterscheidbar ist. Es versteht sich, dass aufgrund der Dokumentation und Fehlermarkierung mittels der Kategoriezuordnung oder mittels des Fehlerfelds im Falle eines fehlerhaften Zugriffs dem Variablenwert auch ein numerischer Fehlerwert, z.B. eine Null, zugeordnet werden kann.

Ein Vorteil des erfindungsgemäßen Verfahrens ist, dass das Auftreten eines Fehlers nicht zu einem Abbruch des Durchlaufs des Steuerprogramms führt. Dadurch, dass der Emulator das Steuerprogramm auch bei auftretenden Fehlern vollständig ausgeführt, ist ein Testen von Teilen des Steuerprogramms möglich. Soll eine einzelne Funktionalität des Steuerprogramms getestet werden, so müssen lediglich alle für die zu testende Funktionalität notwendigen Umgebungswerte in der Simulationsumgebung simuliert und über die Schnittstelle des Emulators in den emulierten Speicherbereich geschrieben werden, da das Fehlen von Umgebungswerten für andere nicht zu testende Funktionalitäten nicht zu einem Abbruch des Steuerprogramms führt.

Ein besonderer Vorteil ist, dass Informationen über eine ursprüngliche Fehlerquelle vererbt werden. So lässt sich nach dem vollständigen Durchlauf des Steuerprogramms für jede Programmvariable direkt anhand der im Datenfeld eingetragenen Adressen der Ursprung eines Fehlers auslesen. Hierdurch werden Informationen über Fehler oder Unvollständigkeiten der erstellten Simulation gezielt hinsichtlich der Programmvariablen, die von Interesse sind, bereitgestellt.

In einer Weiterbildung wird bei der Ermittlung eines Variablenwerts einer ersten Programmvariablen bei einem Zugriff auf eine der zweiten Kategorie zugeordneten Programmvariablen oder auf eine ein Fehlerfeld mit einem ersten Fehlerwert aufweisende zweite Programmvariable eine Kennung der zweiten Programmvariablen in das Datenfeld der ersten Programmvariablen geschrieben. Hierdurch wird der gesamte Weg des Fehlers bzw. die Fehlerfortpflanzung dokumentiert. Als Kennung der Programmvariablen ist jede die Programmvariable eindeutig identifizierende Größe geeignet, beispielsweise der Name der Programmvariablen oder die Speicheradresse der Programmvariablen.

Gemäß einer anderen Weiterbildung wird für den Fall, dass das Steuerprogramm einer der zweiten Kategorie zugeordneten oder ein Fehlerfeld mit einem ersten Fehlerwert aufweisenden ersten Programmvariablen einen vorgegebenen Wert zuweist, die erste Programmvariable als nicht-fehlerbehaftet markiert, der vorgegebene Wert als Variablenwert in dem erweiterten Wertebereich der ersten Programmvariablen abgelegt, wobei bei einer Markierung anhand einer Zuordnung zu einer ersten Kategorie oder zu einer zweiten Kategorie das Datenfeld aus dem erweiterten Wertebereich gelöscht wird und bei einer Markierung anhand eines Fehlerfelds alle Einträge des Datenfelds gelöscht werden. Hierdurch kann die Fehlerfortpflanzung durchbrochen werden. Aufgrund der Zuweisung eines validen Werts wird die Programmvariable wieder als valide markiert bzw. weitergeführt.

In Kombination mit der Dokumentation der Fehlerfortpflanzung eröffnet sich die Möglichkeit, einen Fehler nicht unbedingt am Ursprung zu beheben, z.B. durch Emulieren der notwendigen Speicheradresse, sondern indem einer später folgenden Programmvariablen direkt ein valider Wert zugewiesen wird.

Es versteht sich, dass für den Fall des Markierens anhand einer Kategoriezuordnung eine nicht-fehlerbehaftete und daher der ersten Kategorie zugeordnete Programmvariable kein Datenfeld aufweisen muss. Es ist jedoch möglich auch in dem Wertebereich einer der ersten Kategorie zugeordneten Programmvariablen ein Datenfeld vorzusehen, wobei dieses keine Einträge aufweist. Weisen auch die der ersten Kategorie zugeordneten Programmvariablen ein Datenfeld auf, so wird bei einem Kategoriewechsel einer Programmvariablen von der zweiten Kategorie zu der ersten Kategorie nicht das gesamte Datenfeld aus dem erweiterten Wertebereich gelöscht, sondern lediglich alle Einträge des Datenfelds gelöscht bzw. keine Einträge des Datenfelds übertragen.

In einer anderen Ausführungsform weist das Steuerprogramm mindestens zwei Programmblöcke auf, wobei die Programmblöcke gemäß einer bedingten Verzweigungsvorschrift des Steuerprogramms abhängig von einer Bedingung alternativ ausgeführt werden. Hängt die Bedingung von einer der zweiten Kategorie zugeordneten oder ein Fehlerfeld mit einem ersten Fehlerwert aufweisenden ersten Programmvariablen, also einer fehlerbehafteten erste Programmvariablen ab, so werden alle Programmblöcke ausgeführt. Durch das Ausführen aller alternativen Vorschriften eines Steuerprogramms, werden dem Anwender nach dem Ausführen des Steuerprogramms zu allen möglichen Programmvarianten Informationen bereitgestellt.

Gemäß einer Weiterbildung wird jede weitere Programmvariable, der während der Ausführung der Programmblöcke ein Wert zugewiesen wird, als fehlerhaft markiert, wobei jeweils eine Kopie aller Einträge des Datenfelds der ersten Programmvariablen in das Datenfeld der weiteren Programmvariablen geschrieben wird und wobei dem Variablenwert der weiteren Programmvariablen jeweils der zweite Fehlerwert zugewiesen wird. Hierdurch sind nach Ausführen des Steuerprogramms alle von der der bedingten Verzweigungsvorschrift abhängigen Programmvariablen zuverlässig und einfach zu identifizieren.

Gemäß einer alternativen Weiterbildung werden nach dem Ausführen der Programmblöcke für jede weitere Programmvariable, der das Steuerprogramm sowohl während der Ausführung des ersten Programmblocks als auch während der Ausführung eines weiteren Programmblocks einen Variablenwert zuweist, die zugewiesenen Variablenwerte verglichen. Bei einer Abweichung zwischen den zugewiesenen Variablenwerten wird die weitere Programmvariable als fehlerhaft markiert, dem Variablenwert der weiteren Programmvariablen der zweite Fehlerwert zugewiesen und eine Kopie aller Einträge des Datenfelds der ersten Programmvariablen in das Datenfeld der weiteren Programmvariable geschrieben. Hierdurch wird sichergestellt, dass nur solche Programmvariablen als fehlerbehaftet markiert werden und Informationen über den Ursprung des Fehlers bereitstellen, deren Variablenwert wirklich von der Verzweigungsvorschrift abhängt.

Handelt es sich beispielsweise nur formal um eine bedingte Verzweigung, z.B. wenn die den Programmvariablen in den unterschiedlichen Programmblöcken zugewiesenen Variablenwerte identisch sind, so wird auch kein Fehler markiert oder vererbt. Handelt es sich nur hinsichtlich einer oder mehrerer Programmvariablen um eine rein formale bedingte Verzweigung, beispielsweise für eine einzige Variable A, während die Variablenwerte anderer Programmvariablen von der bedingten Verzweigungsvorschrift abhängen, so wird die eine oder die mehreren Programmvariablen, z.B. die Variablen A, als nicht-fehlerbehaftet markiert, während die anderen Programmvariablen als fehlerbehaftet markiert werden.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert. Darin zeigt:
- Figur 1: eine schematische Ansicht eines Emulators und einer Simulationsumgebung,
- Figur 2: eine schematische Darstellung einer ersten Ausführungsform von Programmvariablen und
- Figur 3: eine schematische Darstellung einer zweiten Ausführungsform einer Programmvariablen.

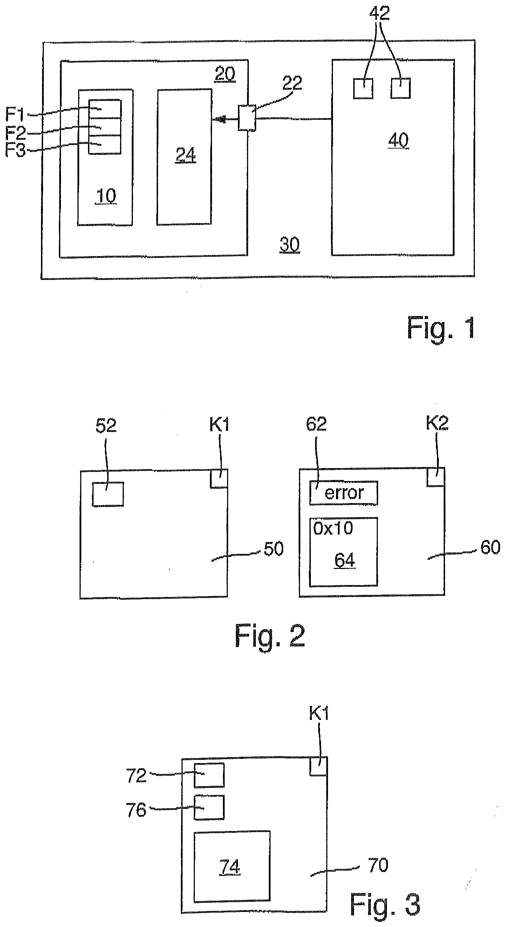

Die Abbildung der Figur 1 zeigt eine Ansicht einer ersten Ausführungsform, wobei ein in Maschinensprache vorliegendes Steuerprogramm 10 für ein Steuergerät (nicht dargestellt) durch einen Emulator 20 auf einem Rechner 30 ausgeführt wird, indem der Emulator einen Prozessor des Steuergeräts und einen Speicherbereich 24 des Steuergeräts nachbildet. Zur Ein- und Ausgabe von Daten weist der Emulator 20 eine Schnittstelle 22 auf.

Um eine oder mehrere Funktionen F1, F2, F3 des Steuerprogramms 10 zu testen, werden im Rahmen einer Simulationsumgebung 40 auf dem Rechner 30 alle Umgebungswerte 42 erzeugt, welche die eine oder die mehreren Funktionen F1, F2, F3 benötigen. Die Umgebungswerte 42 werden dem Emulator 20 zur Verfügung gestellt, indem die Umgebungswerte 42 mittels der Schnittstelle 22 zur Ein- und Ausgabe von Daten in den emulierten Speicherbereich 24 geschrieben werden. Die Umgebungswerte 42 können sowohl Variablen des Steuergeräts repräsentieren, wie durch on-chip Komponenten zur Verfügung gestellte Funktionalitäten, als auch von extern dem Steuergerät übermittelte Daten, z.B. von externen Sensoren.

Während der Ausführung des Steuerprogramms 10 werden Programmvariablen Variablenwerte zugewiesen. Hierfür wird entweder auf eine Speicheradresse im emulierten Speicherbereich 24 oder auf mindestens eine andere Programmvariable zugegriffen. Ist die erstellte Simulationsumgebung bzw. sind die erzeugten Umgebungswerte unvollständig, so können vom Steuerprogramm abgefragte Speicheradressen im emulierten Speicherbereich fehlen oder nicht beschrieben sein. Beides führt zu einem fehlerhaften Variablenwert der Programmvariablen. Entsprechend führt ein Zugriff auf eine fehlerhafte Programmvariable zu einem Folgefehler.

Erfindungsgemäß wird einer Programmvariablen zur Dokumentation eines Fehlers ein erweiterter Wertebereich 50, 60, 70 zugewiesen. Die Abbildung der Figur 2 zeigt auf der linken Seite eine schematische Ansicht einer ersten Programmvariablen. Die dargestellte erste Programmvariable ist nicht-fehlerbehaftet und daher von dem Emulator 20 einer ersten Kategorie K1 zugeordnet. Die erste Programmvariable weist einen Wertebereich 50 auf, wobei der erweiterte Wertebereich 50 den Variablenwert 52 aufweist.

Auf der rechten Seite der Figur 2 ist eine schematische Ansicht einer zweiten Programmvariablen gezeigt, die fehlerbehaftet ist und daher einer zweiten Kategorie K2 angehört. Während der Variablenwert 52 der ersten Programmvariablen einen beliebigen Wert aufweist, ist dem Variablenwert 62 der zweiten Programmvariablen immer der zweite Fehlerwert error zugewiesen. Im Datenfeld 64 der zweiten Programmvariablen ist eine Speicheradresse hinterlegt. Die Speicheradresse entspricht der während des Ausführens des Steuerprogramms 10 für eine Wertzuweisung für die zweite Programmvariable abgefragten Speicheradresse, die entweder im emulierten Speicherbereich 24 nicht vorhanden oder nicht beschrieben ist.

Gemäß dem in Figur 2 gezeigten ersten Ausführungsbeispiel sind für fehlerbehaftete und nicht-fehlerbehaftete Programmvariablen unterschiedliche Kategorien K1, K2 vorgesehen. Tritt ein Fehler durch einen Zugriff auf eine nicht vorhandene oder nicht beschriebene Speicheradresse des emulierten Speicherbereichs auf, so wird die Programmvariable der zweiten Kategorie K2 zugeordnet. Zusätzlich wird dem Variablenwert 62 der zweite Fehlerwert error zugewiesen und die Speicheradresse in das Datenfeld 64 geschrieben. Tritt ein Fehler bei einem Zugriff auf eine andere fehlerhafte Programmvariable auf, so wird die zweite Programmvariable ebenfalls der zweiten Kategorie K2 zugeordnet, dem Variablenwert 62 der zweite Fehlerwert error zugewiesen und zusätzlich werden alle im Datenfeld der anderen fehlerhaften Programmvariablen vermerkten Speicheradressen in das Datenfeld 64 der zweiten Programmvariablen kopiert.

Ein zweites Ausführungsbeispiel ist in Figur 3 dargestellt. Hier weisen alle Programmvariablen einen identisch ausgestalteten erweiterten Wertebereich 70 auf, der neben einem Variablenwert 72 und einem Datenfeld 74 zusätzlich ein Fehlerfeld 76 umfasst. Dem Fehlerfeld 76 einer nicht-fehlerbehafteten Programmvariablen ist ein erster Validitätswert, z.B. 0, zugeordnet. Tritt ein Fehler auf, wird gemäß dem zweiten Ausführungsbeispiel kein Kategoriewechsel vorgenommen, sondern dem Fehlerfeld ein erster Fehlerwert, z.B. 1, zugewiesen.

Durch die Fehlervererbung, also das Schreiben bzw. Kopieren von Speicheradressen in die Datenfelder 64, 74, werden nach dem Durchlauf alle notwendigen Informationen zu aufgetretenen Fehlern bereitgestellt. So ist es möglich, auch nur eine erste Funktionen F1 des Steuerprogramms 10 zu testen, indem nur die für die erste Funktion F1 relevanten Umgebungswerte in der Simulationsumgebung erzeugt und dem Emulator mittels der Schnittstelle 22 bereitgestellt werden. Im Ergebnis werden die Ausgabewerte der weiteren Funktionen F2, F3, die nicht von Interesse sind, fehlerbehaftet sein.

Anhand des Variablenwerts, der Kategorie und/oder des Fehlerfelds der Programmvariablen, die als Ausgabewerte der ersten Funktion F1 geliefert werden, wird festgestellt, ob ein Fehler bei der Ausführung der ersten Funktion F1 aufgetreten ist. Das Datenfeld 64, 74 der Programmvariablen liefert Informationen dazu, an welcher Stelle der Fehler aufgetreten ist und wie er sich fortgepflanzt hat.

## Patentansprüche

1. Verfahren zur Überwachung von Fehlern beim Testen eines Steuerprogramms (10) eines Steuergeräts in einer Simulationsumgebung (40) auf einem Rechner (30),
• wobei die Simulationsumgebung (40) auf dem Rechner (30) erzeugt wird,
• wobei das Steuerprogramm (10) von einem Emulator ausgeführt wird,
• wobei der Emulator auf dem Rechner (30) ausgeführt wird, wobei der Emulator zumindest einen Teil des Steuergeräts mit einem Prozessor und einem Speicherbereich (24) nachbildet und wobei der Emulator (20) eine Schnittstelle (22) zur Ein- und Ausgabe von Daten aufweist,
• wobei Umgebungswerte (42) aus der Simulationsumgebung (40) über die Schnittstelle (22) in den emulierten Speicherbereich (24) geschrieben werden,
• wobei das Steuerprogramm (10) Programmvariablen aufweist,
• wobei das Steuerprogramm (10) zumindest einigen Programmvariablen während der Ausführung des Steuerprogramms (10) einen Variablenwert (52, 62, 72) zuweist,
• wobei der Variablenwert (52, 62, 72) durch einen Zugriff auf eine Speicheradresse des emulierten Speicherbereichs (24) ermittelt wird,
**dadurch gekennzeichnet, dass**
• der Emulator jeder Programmvariablen des Steuerprogramms (10) einen erweiterten Wertebereich (50, 60, 70) zuordnet,
• der einer Programmvariablen zugewiesene Variablenwert (52, 62, 72) in dem erweiterten Wertebereich (50, 60, 70) abgelegt wird,
• der Emulator Programmvariablen als fehlerbehaftet oder nicht-fehlerbehaftet markiert,
• die Markierung anhand einer Zuordnung von nicht-fehlerbehafteten Programmvariablen zu einer ersten Kategorie (K1) und von fehlerbehafteten Programmvariablen zu einer zweiten Kategorie (K2) erfolgt, wobei der erweiterte Wertebereich (60) jeder Programmvariablen der zweiten Kategorie (K2) ein Datenfeld (64) aufweist oder
• die Markierung anhand eines in dem erweiterten Wertebereich (70) hinterlegten Fehlerfelds (76) erfolgt, wobei dem Fehlerfeld (76) einer nicht-fehlerbehafteten Programmvariablen ein erster vorbestimmter numerischer oder nicht-numerischer Validitätswert zugewiesen wird und dem Fehlerfeld (76) einer fehlerbehafteten Programmvariablen ein erster vorbestimmter numerischer oder nichtnumerischer Fehlerwert zugewiesen wird und wobei der erweiterte Wertebereich (70) jeder Programmvariablen ein Datenfeld (74) aufweist,
• dass die Markierung bei der Ermittlung eines Variablenwerts (52, 62, 72) vorgenommen wird,
• wobei bei der Ermittlung eines Variablenwerts (52, 72) einer ersten Programmvariablen bei einem Zugriff des emulierten Prozessors (20) auf eine vorhandene und beschriebene erste Speicherdresse in dem emulierten Speicherbereich (24) oder auf eine zweite Programmvariable, wobei die zweite Programmvariable der ersten Kategorie (K1) zugeordnet ist oder ein Fehlerfeld (72) mit einem ersten Validitätswert aufweist,
▪ die Programmvariable als nicht-fehlerbehaftet markiert wird und ▪
der ermittelte Variablenwert in dem erweiterten Wertebereich (50, 70) abgelegt wird,
• wobei bei der Ermittlung eines Variablenwerts (52, 72) einer ersten Programmvariablen (50, 70) bei einem Zugriff des emulierten Prozessors (20) auf eine nicht vorhandene oder nicht beschriebene zweite Speicherdresse in dem emulierten Speicherbereich (24) oder auf eine dritte Programmvariable, wobei die dritte Programmvariable der zweiten Kategorie (K2) zugeordnet ist oder ein Fehlerfeld (72) mit einem ersten Fehlerwert aufweist,
▪ die erste Programmvariable als fehlerbehaftet markiert wird,
▪ dem Variablenwert (52, 72) der ersten Programmvariablen (50, 70) ein vorbestimmter numerischer oder nicht-numerischer zweiter Fehlerwert zugewiesen wird und
▪ die nicht vorhandene oder nicht beschriebene zweite Speicheradresse oder eine Kopie aller Einträge des Datenfelds (64, 74) der dritten Programmvariablen in das Datenfeld (64, 74) der ersten Programmvariablen geschrieben werden.

2. Verfahren nach Anspruch 1, **dadurch gekennzeichnet, dass** bei der Ermittlung eines Variablenwerts (62, 72) einer ersten Programmvariablen durch Zugriff auf eine der zweiten Kategorie (K2) zugeordnete oder ein Fehlerfeld (72) mit einem ersten Fehlerwert aufweisende zweite Programmvariable eine Kennung der zweiten Programmvariable in das Datenfeld (64, 74) der ersten Programmvariablen geschrieben wird.

3. Verfahren nach Anspruch 1 oder 2, **dadurch gekennzeichnet, dass** für den Fall, dass das Steuerprogramm (10) einer der zweiten Kategorie (K2) zugeordneten oder ein Fehlerfeld (72) mit einem ersten Fehlerwert aufweisenden ersten Programmvariablen einen vorgegebenen Wert zuweist,
• die erste Programmvariable als nicht-fehlerbehaftet markiert wird,
• der vorgegebene Wert als Variablenwert (52, 72) in dem erweiterten Wertebereich (50, 70) der Programmvariablen abgelegt wird,
• wobei bei einer Markierung anhand einer Zuordnung zu einer ersten Kategorie (K1) oder zweiten Kategorie (K2) das Datenfeld (64) aus dem erweiterten Wertebereich (50, 60) gelöscht wird und
• wobei bei einer Markierung anhand eines Fehlerfelds (76) alle Einträge des Datenfelds (74) gelöscht werden.

4. Verfahren nach einem der Ansprüche 1 bis 3, **dadurch gekennzeichnet, dass** für den Fall, dass das Steuerprogramm mindestens zwei Programmblöcke aufweist, wobei die Programmblöcke gemäß einer bedingten Verzweigungsvorschrift des Steuerprogramms abhängig von einer Bedingung alternativ ausgeführt werden und wobei die Bedingung von einer der zweiten Kategorie (K2) zugeordneten oder ein Fehlerfeld (72) mit einem ersten Fehlerwert aufweisenden ersten Programmvariablen abhängt, alle Programmblöcke ausgeführt werden.

5. Verfahren nach Anspruch 4, **dadurch gekennzeichnet, dass** jede weitere Programmvariable, der während der Ausführung der Programmblöcke ein Wert zugewiesen wird, als fehlerbehaftet markiert wird, wobei jeweils eine Kopie aller Einträge des Datenfelds (64, 74) der ersten Programmvariablen in das Datenfeld (64, 74) der weiteren Programmvariablen geschrieben wird und wobei dem Variablenwert (62, 72) der weiteren Programmvariablen jeweils der zweite Fehlerwert zugewiesen wird.

6. Verfahren nach Anspruch 4, **dadurch gekennzeichnet, dass** nach dem Ausführen der Programmblöcke für jede weitere Programmvariable, der das Steuerprogramm (10) sowohl während der Ausführung des ersten Programmblocks als auch während der Ausführung eines weiteren Programmblocks einen Variablenwert (52, 62, 72) zuweist, die zugewiesenen Variablenwerte (52, 62, 72) verglichen werden, wobei bei einer Abweichung zwischen den zugewiesenen Variablenwerten (52, 62, 72),
• die weitere Programmvariable als fehlerbehaftet markiert wird,
• dem Variablenwert (62, 72) der weiteren Programmvariablen der zweite Fehlerwert zugewiesen wird und
• eine Kopie aller Einträge des Datenfelds (64, 74) der ersten Programmvariablen in das Datenfeld (64, 74) der weiteren Programmvariablen geschrieben wird.

## Claims

1. A method for monitoring errors when testing a control program (10) of a control device in a simulation environment (40) on a computer (30),
• the simulation environment (40) being generated on the computer (30),
• the control program (10) being executed by an emulator,
• the emulator being implemented on the computer (30) and the emulator simulating at least one part of the control device having a processor and a memory area (24) and the emulator (20) comprising an interface (22) for inputting and outputting data,
• environmental values (42) from the simulation environment (40) being written into the emulated memory area (24) via the interface (22),
• the control program (10) comprising program variables,
• the control program (10) assigning a variable value (52, 62, 72) to at least a plurality of program variables during executing of the control program (10),
• the variable value (52, 62, 72) being determined by accessing a memory address of the emulated memory area (24),
**characterized in that**
• the emulator associates an expanded value range (50, 60, 70) with each program variable of the control program (10),
• the variable value (52, 62, 72) assigned to a program variable is stored in the expanded value range (50, 60, 70),
• the emulator program variables are marked as defective or non-defective,
• the marking takes place on the basis of an association of non-defective program variables with a first category (K1) and of defective program variables with a second category (K2), wherein the expanded value range (60) of each program variable of the second category (K2) comprises a data field (64), or
• the marking takes place on the basis of an error field (76) saved in the expanded value range (70), wherein a first predetermined numerical or non-numerical validity value is assigned to the error field (76) of a non-defective program variable, and a first predetermined numerical or non-numerical error value is assigned to the error field (76) of a defective program variable, and wherein the expanded value range (70) of each program variable comprises a data field (74),
• and that the marking is performed when determining a variable value (52, 62, 72),
• wherein, when determining a variable value of a first program variable, when the emulated processor (20) accesses a present and described first memory address in the emulated memory area (24) or accesses a second program variable when determining a variable value (52, 72), wherein the second program variable is associated with the first category (K1) or comprises an error field (72) having a first validity value,
▪ the program variable is marked as non-defective, and
▪ the determined variable value is stored in the expanded value range (50, 70),
• wherein, when determining a variable value (52, 72) of a first program variable (50, 70), when the emulated processor (20) accesses a second memory address not present or not described in the emulated memory area (24), or accesses a third program variable, wherein the third program variable is associated with the second category (K2) or comprises an error field (72) having a first error value,
▪ the first program variable is marked as defective,
▪ a predetermined numerical or non-numerical second error value is assigned to the variable value (52, 72) of the first program variables (50, 70), and
▪ the second memory address not present or not described, or a copy of all entries of the data field (64, 74) of the third program variables, are written into the data field (64, 74) of the first program variable.

2. The method according to claim 1, **characterized in that** when determining a variable value (62, 72) of a first program variable by accessing a second program variable associated with the second category (K2) or comprising an error field (72) having a first error value, an identification of the second program variable is written into the data field (64, 74) of the first program variable.

3. The method according to claim 1 or 2, **characterized in that** in the case that the control program (10) assigns a predefined value to a first program variable associated with the second category (K2) or comprising an error field (72) having a first error value,
• the first program variable is marked as non-defective,
• the prescribed value is saved as a variable value (52, 72) in the expanded value range (50, 70) of the program variables,
• wherein for marking using an association with a first category (K1) or second category (K2), the data field (64) is erased from the expanded value range (50, 60), and
• wherein for marking using an error field (76), all entries of the data field (74) are erased.

4. The method according to any one of the claims 1 through 3, **characterized in that** in the case that the control program comprises at least two program blocks, wherein the program blocks are executed alternatively according to a conditioned branching specification of the control program depending on a condition, and wherein the condition depends on a first program variable associated with the second category (K2) or comprising an error field (72) having a first error value, all program blocks are executed.

5. The method according to claim 4, **characterized in that** each further program variable assigned a value when executing the program blocks is marked as defective, wherein one copy each of all entries of the data field (64, 74) of the first program variables is written into the data field (64, 74) of the further program variables, and wherein the second error value in each case is assigned to the variable value (62, 72) of the further program variables.

6. The method according to claim 4, **characterized in that** after executing the program blocks for each further program variable assigned a variable value (52, 62, 72) by the control program (10) both during executing of the first program block and during executing of a further program block, the assigned variable values (52, 62, 72) are compared, wherein in case of a deviation between the assigned variable values (52, 62, 72)
• the further program variable is marked as defective,
• the second error value is assigned to the variable value (62, 72) of the further program variable, and
• a copy of all entries of the data field (64, 74) of the first program variables is written into the data field (64, 74) of the further program variables.

## Revendications

1. Procédé pour surveiller des erreurs lors du test d'un programme de commande (10) d'un appareil de commande dans un environnement de simulation (40) sur un ordinateur (30),
▪ dans lequel l'environnement de simulation (40) est généré sur l'ordinateur (30),
▪ dans lequel le programme de commande (10) est exécuté par un émulateur,
▪ dans lequel l'émulateur est exécuté sur l'ordinateur (30), dans lequel l'émulateur reproduit au moins une partie de l'appareil de commande avec un processeur et une zone de mémoire (24) et dans lequel l'émulateur (20) comporte une interface (22) pour la saisie et la sortie de données,
▪ dans lequel des valeurs d'environnement (42) émanant de l'environnement de simulation (40) sont écrites dans la zone de mémoire émulée (24) via l'interface (22),
▪ dans le lequel le programme de commande (10) comporte des variables de programme,
▪ dans lequel le programme de commande (10) attribue à au moins quelques variables de programme une valeur de variable (52, 62, 72) pendant l'exécution du programme de commande (10),
▪ dans lequel la valeur de variable (52, 62, 72) est déterminée par accès à une adresse en mémoire de la zone de mémoire émulée (24),
**caractérisé en ce que**
▪ l'émulateur attribue à chaque variable de programme du programme de commande (10) une plage de valeurs élargie (50, 60, 70),
▪ la valeur de variable (52, 62, 72) attribuée à une variable de programme est stockée dans la plage de valeurs élargie (50, 60, 70),
▪ l'émulateur marque les variables de programme en tant qu'erronées ou non erronées,
▪ le marquage est effectué sur la base d'une attribution de variables de programme non erronées à une première catégorie (K1) et de variables de programme erronées à une seconde catégorie (K2), sachant que la plage de valeurs élargie (60) de chaque variable de programme de la seconde catégorie (K2) présente un champ de données (64) ou
▪ le marquage est effectué sur la base d'un champ d'erreur (76) stocké dans la plage de valeurs élargie (70), sachant qu'une première valeur de validité prédéterminée numérique ou non numérique est attribuée au champ d'erreur (76) d'une variable de programme non erronée et une première valeur d'erreur prédéterminée numérique ou numérique est attribuée au champ d'erreur (76) d'une variable de programme erronée et sachant que la plage de valeur élargie (70) de chaque variable de programme présente un champ de données (74),
▪ que le marquage est effectué lors de la détermination d'une valeur de variable (52, 62, 72),
▪ dans lequel, lors de la détermination d'une valeur de variable (52, 72) d'une première variable de programme lors d'un accès du processeur émulé (20) à une première adresse en mémoire existante écrite dans la zone de mémoire émulée (24) ou à une seconde variable de programme, sachant que la seconde variable de programme est attribuée à la première catégorie (K1) ou présente un champ d'erreur (72) avec une première valeur de validité,
- la variable de programme est marquée en tant que non erronée et
- la valeur de variable déterminée est stockée dans la plage de valeur élargie (50, 70),
▪ dans lequel, lors de la détermination d'une valeur de variable (52, 72) d'une première variable de programme (50, 70) lors d'un accès du processeur émulé (20) à une seconde adresse en mémoire non existante ou non écrite dans la zone de mémoire émulée (24) ou à une troisième variable de programme, sachant que la troisième variable de programme est attribuée à la seconde catégorie (K2) ou présente un champ d'erreur (72) avec une première valeur d'erreur,
- la première variable de programme est marquée en tant qu'erronée et
- une seconde valeur d'erreur prédéterminée numérique ou non numérique est attribuée à la valeur de variable (52, 72) de la première variable de programme (50, 70) et
- la seconde adresse en mémoire non existante ou non écrite ou une copie de toutes les mentions du champ de données (64, 74) de la troisième variable de programme est écrite dans le champ de données (64, 74) de la première variable de programme.

2. Procédé selon la revendication 1, **caractérisé en ce que**, lors de la détermination d'une valeur de variable (62, 72) d'une première variable de programme par accès à une seconde variable de programme attribuée à la seconde catégorie (K2) ou présentant un champ d'erreur (72) avec une première valeur d'erreur, un identificateur de la seconde variable de programme est écrit dans le champ de données (64, 74) de la première variable de programme.

3. Procédé selon la revendication 1 ou 2, **caractérisé en ce que**, dans le cas où le programme de commande (10) attribue une valeur prédéterminée à une première variable de programme attribuée à la seconde catégorie (K2) ou présentant un champ d'erreur (72) avec une première valeur d'erreur,
▪ la première variable de programme est marquée en tant que non erronée,
▪ la valeur pré-allouée est stockée en tant que valeur de variable (52, 72) dans la plage de valeur élargie (50, 70) de la variable de programme,
▪ sachant qu'en cas de marquage sur la base d'une attribution à une première catégorie (K1) ou une seconde catégorie (K2), le champ de données (64) est supprimé de la plage de valeurs élargie (50, 60) et
▪ sachant qu'en cas de marquage sur la base d'un champ d'erreur (76), toutes les mentions du champ de données (74) sont supprimées.

4. Procédé selon l'une des revendications 1 à 3, **caractérisé en ce que**, dans le cas où le programme de commande comporte au moins deux blocs de programme, sachant que les blocs de programme sont exécutés en alternative conformément à une instruction de ramification conditionnelle du programme de commande en fonction d'une condition et sachant que la condition dépend d'une variable de programme attribuée à la seconde catégorie (K2) ou présentant un champ d'erreur (72) avec une première valeur d'erreur, tous les blocs de programme sont exécutés.

5. Procédé selon la revendication 4, **caractérisé en ce que** chaque variable de programme supplémentaire à laquelle est attribuée une valeur pendant l'exécution des blocs de programme, est marquée en tant qu'erronée, sachant qu'une copie de toutes les mentions du champ de données (64, 74) de la première variable de programme est respectivement écrite dans le champ de données (64, 74) de la variable de programme supplémentaire et sachant que la seconde valeur d'erreur est respectivement attribuée à la valeur de variable (62, 72) de la variable de programme supplémentaire.

6. Procédé selon la revendication 4, **caractérisé en ce qu'**après l'exécution des blocs de programme pour chaque variable de programme supplémentaire à laquelle le programme de commande (10) attribue une valeur de variable (52, 62, 72) aussi bien pendant l'exécution du premier bloc de programme que pendant l'exécution d'un bloc de programme supplémentaire, les valeurs de variable attribuées (52, 62, 72) sont comparées, sachant qu'en cas d'écart entre les valeurs de variable attribuées (52, 62, 72),
▪ la variable de programme supplémentaire est marquée en tant qu'erronée,
▪ la seconde valeur d'erreur est attribuée à la valeur de variable (62, 72) de la variable de programme supplémentaire et
▪ une copie de toutes les mentions du champ de données (64, 74) de la première variable de programme est écrite dans le champ de données (64, 74) de la variable de programme supplémentaire.
